Europäisches Patentamt

European Patent Office

Office européen des brevets

(11) Publication number: **0 474 916 A2**

# EUROPEAN PATENT APPLICATION

(21) Application number: **90124446.7**

(22) Date of filing: **17.12.90**

(51) Int. Cl.5: **H03B 19/00**

(30) Priority: **14.09.90 YU 1751/90**

(43) Date of publication of application:
**18.03.92 Bulletin 92/12**

(84) Designated Contracting States:
**AT CH DE FR GB IT LI SE**

(71) Applicant: **Eferl, Franc**
**Pri soli 45**
**YU-62351 Kamnica, Slovenia(YU)**
Applicant: **Zatler, Andrej**
**Askerceva 24**
**YU-62000 Maribor, Slovenia(YU)**

(72) Inventor: **Eferl, Franc**
**Pri soli 45**
**YU-62351 Kamnica, Slovenia(YU)**
Inventor: **Zatler, Andrej**
**Askerceva 24**
**YU-62000 Maribor, Slovenia(YU)**

(74) Representative: **Lewald, Dietrich, Dipl.-Ing. et al**
**Patentanwälte Deufel, Hertel, Lewald**
**Isartorplatz 6 Postfach 26 02 47**
**W-8000 München 26(DE)**

(54) Frequency multiplier with analog function generator with linear electronic components.

(57) The invention is relating to the frequency multiplier with the analog function generator with linear electronic components, having the function of multiplying the input linear and non-linear periodic or non-periodic optional functions of the electric voltage (V 1.1) in the analog electronic circuit, the functions being direct current or alternating current and of any quantity, the output function (V4), at the output of the frequency multiplier with the analog function generator with linear electronic components, being just an imitation of the multiplied input function of the electric voltage (V 1.1) which is by its form equal to the input function (V 1.1) and differs only in the increased frequency while the output function of the electric voltage (V4) can only be transformed partially or in whole with the frequency increased where all output functions (V4) keep their analog character.

The frequency multiplier with the analog function generator with linear electronic components will find its sphere of application in electronics and other technical branches to a very wide extent as it in principle indicates a completely new and up-till-now not know approach what makes us inticipate its mass applicability in all fields of technique.

Fig. 1

## Field of technique

The field of technique to which the present invention belongs are electronic analog frequency multipliers, the invention relating concretely to operational amplifiers of electric voltage with the appertaining linear resistors, having a function of transforming and multiplying the input frequency, respectively.

The foreseen classification of the patent subject according to IPC are the basic electronic circuits for the generation of oscillations by frequency multiplication classified in the class H 03B 19/00 and further on, devices in which the arithmetic operations are performed by changing of electrical quantities, classified in the class G 06G 7/16 and, further on, the amplifiers classified in the class H 03F 1/32.

## Technical problem

The invention solves the problem how to multiply the input linear and non-linear periodically repeating or non-repeating input functions of the voltage in the analog electronic circuits which can be D.C or A.C., and that, in any quantity, the output function being just an imitation of a multiplied input function which is by a form equal to the input function but for the increased frequency, however, the output function can be transformed and have the frequency increased where the output functions keep their analog character.

At the same time the invention solves the problem how, inspite of the transforming frequency at the input, to obtain at the analog electronic circuits output the determined and calculated multiple of this frequency, namely, in the very moment when the change appears at the input of this electronic circuit with the desired or required form and magnitude of the voltage amplitude.

Thus, the invention solves also the problem of the voltage output frequency time response to the voltage input frequency. The invention furthermore solves the problem how to express every, even the smallest, change of the analog voltage at the input of the frequency multiplier with the analog function generator also at its output with any required form, magnitude and frequency of the output signal. The invention, thus also solves the problem how to express every change of the analog input voltage at the output of the frequency multiplier with the analog function generator, by the calculated number of amplitudes and the frequency, respectively, of the analog characteristic electric voltage.

Thus, the invention solves the problem how to increase the accuracy of determining the value of the analog voltage input change and, how to obtain the required and the desired discrete quality of this analog voltage in the electronic circuit.

## State of technique

Up-to-now known frequency multipliers operate on the principle of the voltage basic frequency amplitude filtration or on the principle of the electric signal comparison.

The disadvantage of the analog frequency multipliers operating on the principle of the basic frequency amplitude filtration is that it is necessary with every change of the basic function to modify or change the components of their electronic circuits and that they are not capable to filter a great or any number of harmonic frequencies by one circuit only. The analog frequency multipliers operating on the principle of comparing the electrical signal have the disadvantage that at the output of their electronic circuits appears a digital signal and, due to this the electric voltage output signal of this frequency multiplier loses the analog character of the input signal.

Yet another disadvantage of this analog frequency multiplier is that it is not capable to compare a greater or any number of the analog input signal points.

The up-to-now known analog frequency multipliers thus have the disadvantage and the weakness that the construction of their electronic circuitry strictly depends upon the basic frequency value where, if we want to change the basic frequency, we shall modify or change the analog electronic circuit components.

Furthermore, the up-to-now known analog frequency multipliers have the disadvantage and the weakness, respectively, that they change the character of the electrical signal from the analog to the digital one.

Yet another disadvantage and the weakness, respectively, of the up-to-now known analog frequency multipliers is that they do not provide the increase of the input frequency at the output by any multiple.

From the German patent application OS 2 202 674, applied by the French applicant MAYER FERDY, Grenoble a parametric frequency multiplier is known which in substance represents an electronic circuit with a frequency feedback - loop comprised of a phase discriminator with two inputs, a low-pass filter, further, of a voltage controlled oscillator and a frequency divider.

In the phase discriminator the phases of two frequencies are discriminated, the phase difference is guided across the low-pass filter to the input of the voltage controlled oscillator which, under the infuence of this voltage, oscillates on the beforehand calculated frequency. Across the feedback - loop represented by the frequency divider, the output frequency has the possibility of a different influence upon the phase discriminator operation where the output frequency obtained, is proportional to a square, a square root or a multiple value of the input frequency.

The weak point and the disadvantage of this known above described invention with a function of a frequency multiplication is first of all in the fact that it is necessary for different input frequencies and for different multiplication factors, to change in the feedback loop the $R_c$ constant of the voltage-controlled oscillator and the capacitor in the low-pass filter. Hence it follows that the parametric frequency multiplier according to this known invention is not capable to multiply, with the electronic circuit parameters unchanged and equal, respectively, the optionally selected frequencies.

Further, another disadvantage and the weakness of this known invention, respectively, is that the output frequency is in substance always an integer multiple ($F^2$, VF, F.N) of the input frequency what in fact means that the output frequency cannot be changed continuously in relation to the input frequency but only in a series of jumps determined by the frequency feedback - loop.

Another disadvantage and weakness of this known invention is also that during the multiplication operation of the input frequencies lower than 1 Hz, appear some system troubles.

Yet another weakness and a disadvantage of this known invention with dynamic changes is also that the responses at the output of the parametric frequency multiplier are not available in a moment but that a definite period of time is needed for an output response within which the output frequencies are transferred via the feedback - loop to the phase discriminator input and only at this moment the latter starts acting on the VCO.

Yet another disadvantage of this known invention is that this parametric frequency multiplier has a limited frequency multiplication factor that ranges about 1000.

Presentation of the invention and a description of the technical problem solution based on an example of embodiment and a description of figures

Regarding the preliminary described weaknesses and disadvantages of the up-to-now known frequency multipliers and, with reference to this, the stated technical problems, the latter will be solved by the frequency multiplier with the analog function generator with linear electronic components according to our invention, indicated in the patent claim, having a function of multiplying the input linear and non-linear, periodic and non-periodic electric voltage functions in the analog electronic circuits which can be D.C. or A.C. with linear electronic components and which in principle consists of three or more operational amplifiers with the appertaining linear resistors which are interconnected by four or more summing junctions which can be optionally generated so that at the voltage output the frequency response is obtained whose amplitudes are composed of the sum and the difference of two or more voltages from the summing junctions.

The invention will be presented more in detail on base of an embodiment example and the accompanying figures, illustrating the following:

Fig. 1    electronic circuit diagram of the frequency multiplier with the analog function generator with linear electronic components,

Fig. 2    saw-tooth wave of the electric voltage

Fig. 3    linear function of the electric voltage whose input function is divided to the optional even number of equal portions,

Fig. 4    linear function of the electric voltage whose input function is divided to the optional even number of unequal portions

Fig. 5    non-linear function of the electric voltage.

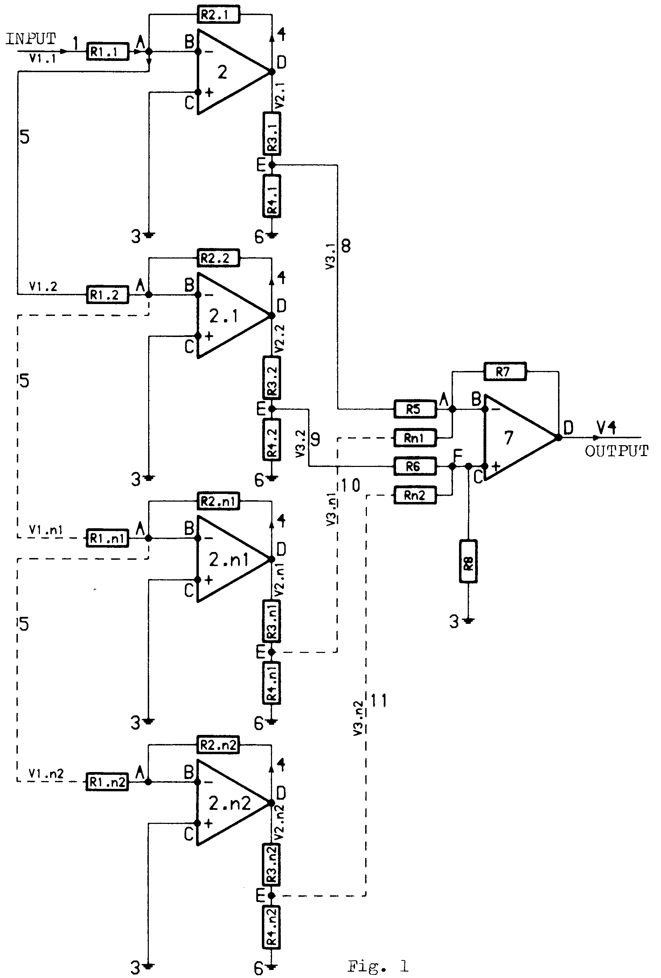

Fig. 1 illustrates that the electric voltage V 1.1 is supplied to the input by the terminal (1) across the resistor R 1.1 into the summing junction A and further on into the inverting input B of the operational amplifier (2) where the supplied voltage V 1.1 gets amplified by the voltage V 2.1 which through the voltage output D of the operational amplifier (2) and through the feedback connection (4) and across the resistor R 2.1 flows back to the summing junction A and that, with the inverted phase. The amplified voltage V 2.1 is dependent on the resistor ratio R 2.1 : R 1.1 what represents the actual voltage gain factor.

The output voltage V 2.1 follows the input voltage V 1.1, taking into consideration the above described voltage gain factor for such a period of time and up to the moment, respectively, until the operational amplifier (2) comes to the state of an electrical saturation (this happens at the instant when the output voltage V 2.1 cannot rise anymore, namely due to the supply voltage height and the internal resistors, in the operational amplifier (2)). The voltage in the summing junction A equals to 0V (zero volts) up to the moment when the operational amplifier (2) comes to the saturation point. At the moment when the operational amplifier (2) reaches the saturation point the output voltage V 2.1 (via the feedback connection (4) and the resistor R 2.1) loses its effect on the summing junction A and, due to this, the voltage in the summing junction A starts rising, and that, in accordance with the rising input voltage V 1.1. This means that the magnitude of the input voltage V 1.1 up to which the voltage in the summing junction A will be zero volts (0V), depends on the described voltage gain factor. The above described phenomenon represents the operation base of the analog function generator with electronic linear components according to our invention in the way as well illustrated in Fig. 1:

The summing junction A of the operational amplifier (2) is by the terminal (5) and across the resistor R 1.2 connected to the next summing junction A of the operational amplifier (2.1) where the input voltage V 1.2 is supplied by the terminal (5) whereupon the operational amplifier (2.1) begins to operate on fully identical principle as the previously described operational amplifier (2). The analog function generator with electronic linear components according to our invention can be formed and composed, respectively of any desirable even number of operational amplifiers (2.n) and the appertaining resistors (R 1.n2, R 2.n2, R 3.n2, R 4.n2) and that in dependence upon the need of generating any desirable or required number of summing junctions An, respectively, foreseen by a mathematical function.

Furthermore, the output voltage V 2.1 is lead from the voltage output D of the operational amplifier (2) across the resistors R 3.1 and R 4.1 into the earthing (6) where a definite portion of the output voltage V 2.1 is taken off from the junction E positioned between the resistors R 3.1 and R 4.1, as a partial voltage V 3.1 , by the terminal (8) and across the resistor R5 and through the summing junction A into the inverting input B of the operational amplifier (7). The output voltage V 2.2 of the operational amplifier (2.1) is lead off from the voltage output D across the resistors R 3.2 and R 4.2 as a partial voltage V 3.2 from the junction E by the terminal (9) and across the resistor R6 and the summing junction F into the noninverting input C of the operational amplifier (7).

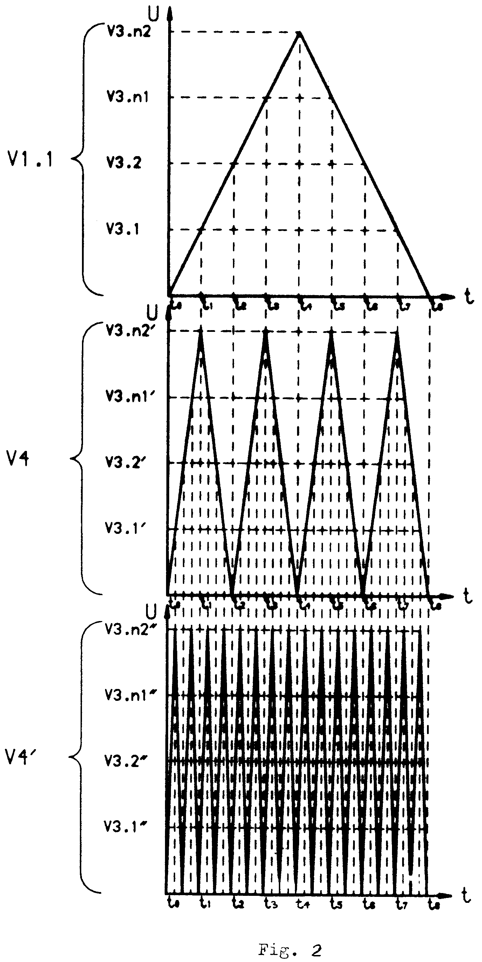

According to the same principle and in the same way also the output voltages V 3.n1 and V 3.n2 of the other operational amplifiers (2.n1) and (2.n2) installed in the electronic circuit, are lead, the frequency multiplier with the analog function generator with linear electronic components according to our invention being composed of at least three and 2n + 1 operational amplifiers, respectively. When at the summing junction A of the operational amplifier (7) the voltage V 3.1 increases, it, being amplified in the voltage gain determined by the resistor ratio R7 : R5, appears at the output D of the operational amplifier (7) with the inverted phase and represents the first part of the desired amplitude. When V 3.1 stops increasing, then, due to the above described operation of the operational amplifier (2), the voltage V 3.2 will start increasing and across the resistor R6 and the summing junction F it will appear at the noninverting junction C of the operational amplifier (7), the gain being determined by the resistor ratio

$$\frac{R8+R6}{R6}$$

at the output D of the operational amplifier (7) what means that this voltage gain is being subtracted from the voltage gain of V 3.1 and represents the other part of the amplitude. In case when the voltage gain factors of R7 : R5 and

$$\frac{R8+R6}{R6}$$

are equal, the first and the second part of the amplitude are equal, as well. According to the same principle we also add and subtract all partial amplified voltages V 3.1 and V 3.n2. At the output D of the operational amplifier (7) we obtain, due to the described principle of adding up and subtracting all amplified partial voltages, a periodically oscillating analog voltage V4 whose frequency depends upon the voltage V 1.1 frequency at the input into the frequency multiplier with the analog function generator with linear electronic components and upon the even number of the operational amplifiers (2, 2.1, 2.n1, 2.n2) which represents the multiplication factor of the input frequency of V 1.1. The practical applicability of the frequency multiplier with the analog function generator with linear electronic components according to our invention, previously described in Fig. 1, will be clearly shown in four characteristic examples, illustrated in Figs. 2, 3, 4 and 5.

From the Fig. 2 it is evident that to the input of the frequency multiplier with the analog function generator with linear electronic components, shown in Fig. 1 we apply a saw-tooth wave of the voltage V 1.1 which is in our case divided into four equal voltage portions (V 3.1, V 3.2, v 3.n1, V 3.n2) in the operational amplifiers (2, 2.1, 2.n1, 2.n2) shown in Fig. 1.

Additionally, the voltage V 3.1 appears within the time t1 at the output D of the amplifier (7) as the output voltage V4 which forms within the time period t1 the first part of the amplitude. The voltage V 3.2 setting in within the time period t2 and appearing at the output D of the amplifier (7) as the output voltage V4, forms within the time period t2 the second part of the amplitude. According to the same principle and in the same manner all further amplitudes of the electric voltages V 3.n1, V 3.n2 are formed within the time period t3 and t8. Everything described above is valid also for the second part of the saw-tooth shaped function. From the above described it can be perceived that one period of the input saw-tooth wave voltage has been frequency-multiplied four times. Provided, we wish to multiply this way obtained frequency further on, we would connect the output D of the operational amplifier (7), shown in Fig. 1 to the input of the following, fully identical frequency multiplier with the analog function generator with linear electronic components. Thus, further on, the basic partial voltage V 3.1, appearing at the output D of the operational amplifier (7) as the output voltage V4, is in the following equal frequency multiplier divided into the partial voltages (V 3.1', V 3.2', V 3.n1', and V 3.n2'). The frequency at the output D of the second operational amplifier (7) multiplies again for four times, where we obtain, according to the above described manner, from one period of the saw-tooth voltage at the input, sixteen output saw-tooth voltages. The procedure of multiplying the saw-tooth shaped functions frequencies can be repeated as many times as desired, namely, up to the limits of the frequency capability of the frequency multiplier electronic circuit components with the analog function generator with linear electronic components according to our invention. In our previously described example the multiplication factor in one circuit equals to 4, what means that in the nth series-connected frequency multiplier the multiplication factor of the input frequency, according to our invention will be $4^n$. The input saw-tooth shaped function can be by the number of the applied operational amplifiers (2.n1, 2.n2) divided into any desired number of equal or unequal partial voltages where we can obtain any optional or required multiplication factor.

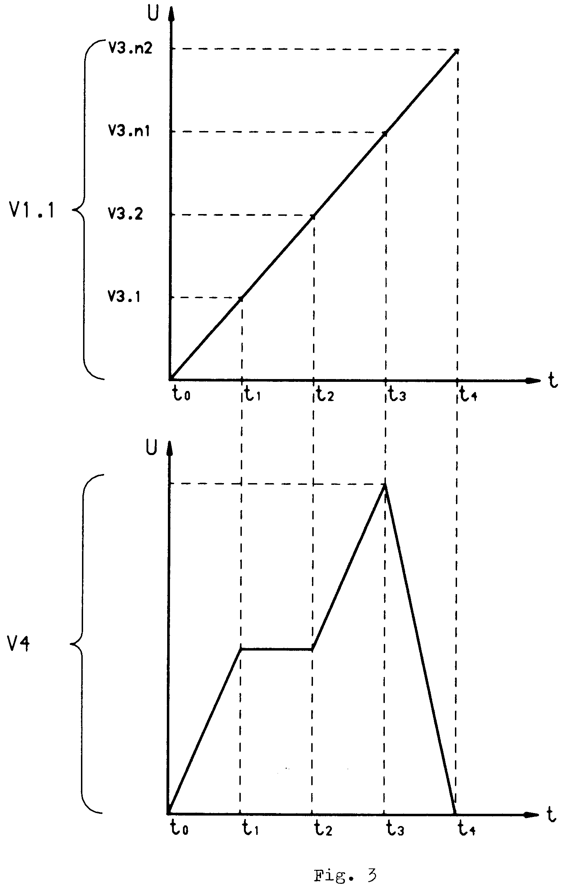

From Fig.3 it can be perceived that at the input of the frequency multiplier with the analog function generator with linear electronic components, according to our invention, the evenly increasing linear function of the voltage V 1.1 is supplied, divided into four equal portions (V 3.1, V 3.2, V 3.n1, V 3.n2) which are further on amplified and multiplied according to the same principle as per description to the Fig. 2, but for the voltage gain factors in the operational amplifiers (2, 2.1, 2.n1, 2.n2) which are not equal but optionally different. Due to their diversity we obtain at the output D of the operational amplifier (7) shown in Fig.1, a function of the voltage V4 shown in Fig. 3.

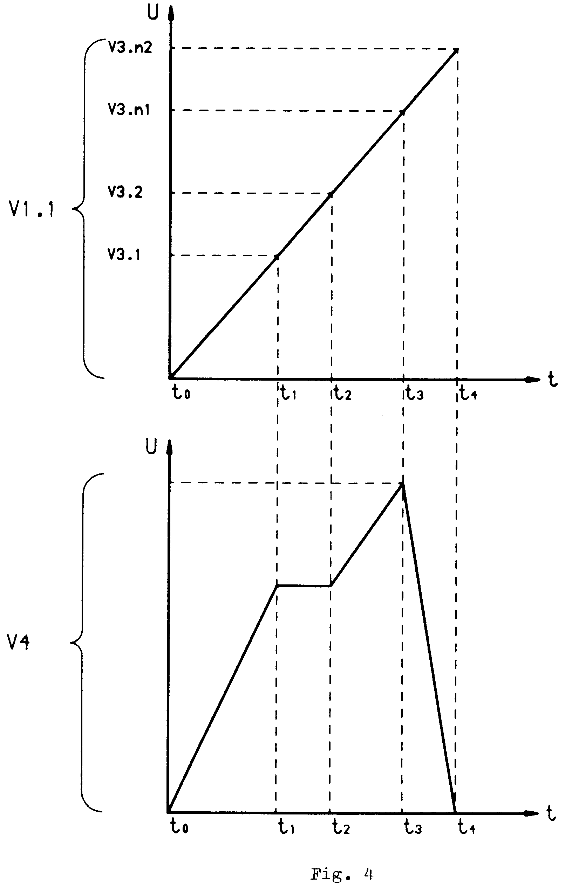

From the Fig. 4 it is evident that to the input of the frequency amplifier according to our invention also the evenly increasing linear function of the voltage V 1.1 is supplied as in the case shown in Fig. 3, but which is divided into four unequal partial voltages (V 3.1, V 3.2, V 3.n1, V 3.n2) which are further amplified and multiplied according to the same principle as described with Fig. 2.

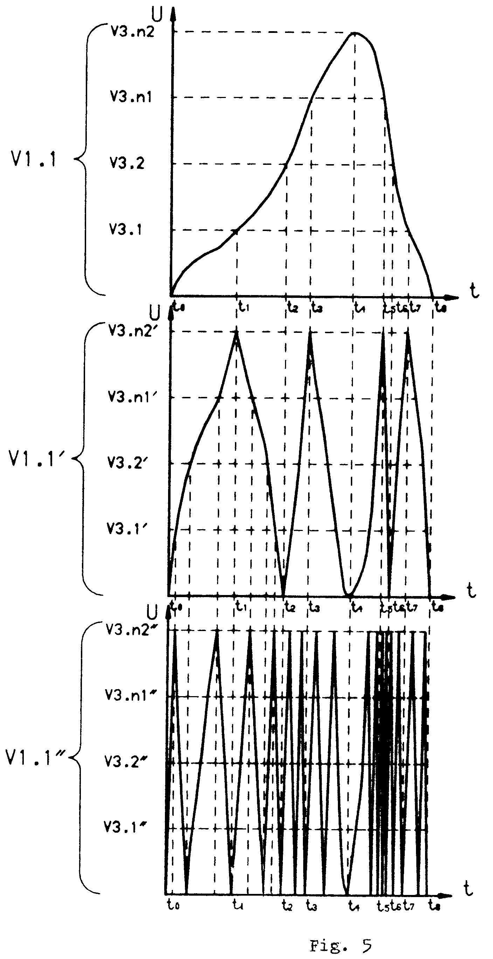

From the Fig. 5 it can be perceived that to the input of the frequency multiplier according to our invention we supply the non-linear function of the electric voltage V 1.1 being periodic or non-periodic which is in our case also divided into four equal partial voltages (V 3.1, V 3.2, V 3.n1, V 3.n2) which are further amplified and multiplied according to the same principle as described with the Fig. 2.

For all previously described cases of the supplied functions, shown in Figs. 2, 3, 4 and 5 it is valid that the supplied functions can be of any desirable form or size, that they can be periodic or non-periodic and that they can be direct current (D.C) or alternating current (A.C). Furthermore, for the cases described above it is characteristic, as well, that the influence of the output voltages (V 2.1, V 2.2, V 2.n1, V 2.n2) from the junction D of the operational amplifiers (2, 2.1, 2.n1, 2.n2) and across the resistors- (R 2.1, R 2.2, R 2.n1, R 2.n2) to the summing junction A of the above said operational amplifiers can be in different embodiment examples limited, besides the already described voltage saturation point in the previously mentioned operational amplifiers, also by other, up-to-now known methods of the electric voltage limitation.

For the previously described frequency multiplier in Fig. 1 it is valid that the described input functions are divided into $2^{n+1}$-partial voltages (V 3.n1, V 3.n2), that the voltage gain factors of the operational amplifiers (2.n1, 2.n2) can be optionally different; furthermore, that also the sequence of the partial voltages (V 3.n1, V 3.n2) connections to the inverting input B or non-inverting input C of the operational amplifier (7) can be different, and, furthermore, that the voltage gain factors of the operational amplifier (7) R7:Rn1 and (R8 + Rn2):Rn2 can be equal or different and stable or changeable.

For all previously described cases and for all cases not described it is valid that the output D of the first multiplier can be at the same time an input for the next, in series connected frequncy multiplier according to our invention.

The universality of the use in all fields of electronics, the simplicity of the construction and a simple and cheap workmanship and assembly based on the use of on a mass scale existing constituent elements, it provides still undreamed-of large range of a frequency multipliers application according to our invention, namely, in the form of an individual construction or in the performance of a large integration of electronic components (chips).

**Claims**

1. The frequency multiplier with analog function generator with linear electronic components, having a function of multiplying and transforming linear, non-linear, periodic, non-periodic, direct current and alternating current functions of input electric voltages, comprising a determined number of operational amplifiers with the appertaining linear resistors, **being characterized in** that the dividing junction (E) positioned between the linear resistors (R 3.1, R 4.1), by the terminal (8) and across the linear resistor (R5) is connected with the summing junction (A) and, further, with the inverting input (B) of the operational amplifier (7).

2.    The frequency multiplier with the analog function generator with linear electronic components according to the claim 1, **being characterized in** that the dividing junction (E) positioned between two linear resistors (R 3.2, R 4.2) is by the terminal (9) and across the linear resistor (R6), connected with the summing junction (F) and, further on, with the Non-inverting input (C) of the operational amplifier (7) with the dividing junctions (F) between the following pairs of the linear resistors (R 3.n1 - R 4.n1, R 3.n2-R 4.n2) being, by the terminals (10, 11) and across the linear resistors (R n1, R n2), connected with the summing junction (A, F) of the operational amplifier (7).

3.    The frequency multiplier with the analog function generator with linear electronic components according to the claim 1, **being characterized in** that we guide the partial electric voltages (V 3.1, V 3.2, V 3.n1, V 3.m2) from the dividing junctions (F) across the terminals (8, 9, 10, 11) and across the linear resistors (R5, R6, R n1, R n2) in the sequence dictated and required, respectively, by the output function V4 from the operational amplifier (7) into two or more summing junctions (A,F) and, further on, into the inverting input(B) and into the non-inverting input (C) of one or more operational amplifiers (7).

4.    The frequency multiplier with the analog function generator with linear electronic components according to the claim 1, **being characterized in** that the number of the operational amplifiers (2, 2.1, 2.n1, 2.n2) in the analog function generator is always a pair one.

Fig. 1

Fig. 2

Fig. 3

Fig. 4

Fig. 5